# EUROPEAN PATENT APPLICATION

(11) **EP 4 779 870 A2**
(43) Date of publication of application: **22.07.2026**
(21) Application number: 25216185.6
(22) Date of filing: 17.11.2025
(51) Int. Cl.: H03K 17/06

(54) **BOOTSTRAPPED SWITCH CIRCUIT WITH HIGH LINEARITY**

(30) Priority: 15.01.2025 US 202519021792
(71) Applicant: Semiconductor Components Industries, LLC, Scottsdale, AZ 85250 (US)
(72) Inventor: BILLA, Arlind, 2000 Neuchatel (CH)
(74) Representative: Manitz Finsterwald Patent- und Rechtsanwaltspartnerschaft mbB

(57) **Abstract**

A bootstrapped switch circuit is disclosed. The bootstrapped switch circuit includes a sample transistor having a source coupled to an input terminal and a drain coupled to an output terminal. The bootstrapped switch circuit further includes a charge path to charge a bootstrap capacitor during a hold phase and a bootstrap path configured to apply a voltage of the bootstrap capacitor to the gate of the sample transistor during a sample phase. The bootstrap path includes a low-side transistor configured to couple a first terminal of the bootstrap capacitor to the source of the sample transistor during the sample phase, and a high-side transistor configured to couple a second terminal of the bootstrap capacitor to the gate of the sample transistor during the sample phase. The bootstrapped switch circuit further includes a bootstrap transistor bootstrap transistor configured to maintain an on-state of the high-side transistor during the sample phase.

## Description

### TECHNICAL FIELD

The disclosure relates generally to electrical circuits, and particularly to a bootstrapped switch with high linearity.

### BACKGROUND

An analog-to-digital converter (ADC) is an electrical circuit that may convert an analog input signal into a digital signal that represents the value of the analog signal. One type of ADC is a Succussive Approximation Register (SAR) ADC. A sampling circuit may be utilized at the input of the SAR ADC to sample the analog input signal that is to be converted into a digital signal. A switch within the sampling circuit may couple an input terminal of the SAR ADC to internal sampling circuitry. The inventor of embodiments of the present disclosure has recognized that the accuracy of the SAR ADC may be limited by the linearity of the switch. The inventor of embodiments of the present disclosure has also recognized that the speed of the SAR ADC may be limited by the speed of the switch. Embodiments of the present disclosure may address one or more of these challenges.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1 illustrates a schematic diagram of an ADC in accordance with embodiments of the present disclosure.
FIG. 2 illustrates a schematic diagram of a sample circuit in accordance with embodiments of the present disclosure.
FIG. 3A illustrates a schematic diagram of a signal generator in accordance with embodiments of the present disclosure.
FIG. 3B illustrates a plot diagram of waveforms generated by a signal generator in accordance with embodiments of the present disclosure.
FIG. 4 illustrates a transistor-level schematic diagram for a bootstrapped switch circuit in accordance with embodiments of the present disclosure.

### DETAILED DESCRIPTION

Details of one or more embodiments are set forth in the description below and the accompanying drawings. Other features will be apparent from the description, drawings, and from the claims. The embodiments disclosed should not be interpreted, or otherwise used, as limiting the scope of the disclosure, including the claims. In addition, one skilled in the art understands that the following description has broad application, and the discussion of any embodiment is meant to be exemplary of that embodiment, and not intended to intimate that the scope of the disclosure, including the claims, is limited to that embodiment.

Various terms are used to refer to particular system components. Different companies may refer to a component by different names, and this disclosure does not intend to distinguish between components that differ in name but not form and function. In the following discussion and in the claims, the terms "including" and "comprising" are used in an open-ended fashion, and thus should be interpreted to mean "including, but not limited to." Also, the term "couple" or "coupled" is intended to mean either an indirect or direct connection. Thus, if a first device couples to, or is coupled to, a second device, that connection between the first device and the second device may be through a direct connection or through an indirect connection via other devices and connections.

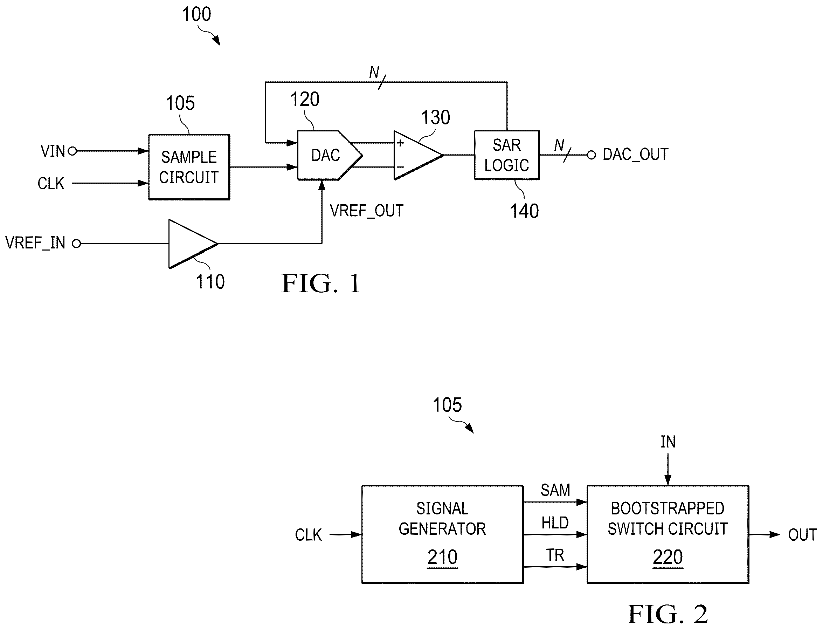

FIG. 1 illustrates a schematic diagram of ADC 100 in accordance with embodiments of the present disclosure. ADC 100 may be implemented in any suitable fashion according to the operation described in the present disclosure. In some embodiments, ADC 100 may include sample circuit 105, digital to analog converter (DAC) 120, comparator 130, successive-approximation register (SAR) logic 140, and reference buffer 110.

Reference buffer 110 may receive a reference input voltage VREF_IN. Reference buffer 110 may buffer VREF_IN and provide a reference output voltage VREF_OUT. In some embodiments, VREF_OUT may be equal to the reference input voltage VREF_IN. Reference buffer 110 may be configured to provide a stable reference output voltage VREF OUT despite varied loading from DAC 120 during successive sample and conversion phases of the conversion process.

Sample circuit 105 may be configured to receive an input voltage VIN from an input terminal of ADC. Sample circuit 105 may alternate between a sample phase and a hold phase based on the clock signal CLK. During the sample phase, sample circuit 105 may pass the input voltage VIN to DAC 120. For example, as described in further detail below with reference to FIGS. 2-4, sample circuit 105 may include a bootstrapped switch circuit that may be configured to pass an input signal from an input terminal of the bootstrapped switch circuit to an output terminal of the bootstrapped switch circuit during the sample phase. Further, the bootstrapped switch circuit may be further configured to isolate the input terminal of the bootstrapped switch circuit from the output terminal of the bootstrapped switch circuit during the hold phase.

DAC 120 may be configured to receive an input signal, such as the input voltage VIN, during the sample phase of the bootstrapped switch circuit within sample circuit 105. DAC 120 may also receive the buffered reference output voltage VREF_OUT from reference buffer 110. In addition, DAC 120 may receive a digital feedback signal from SAR logic 140 with an *N* number of bits. DAC 120 may be a capacitive digital-to-analog converter (capacitive DAC) that uses switched capacitor circuitry to sample the input voltage VIN. For example, DAC 120 may include an *N* number of switched capacitor circuits, each corresponding to one of the *N* number of bits of SAR logic 140. Each of the *N* number of switched capacitor circuits may include a capacitor with a capacitance that is scaled to its respective corresponding bit position.

To generate an N-bit digital output, ADC 100 may proceed through a sample phase and an *N* number of successive conversion steps during the hold phase. Because the *N* number of successive conversion steps may be performed by ADC 100 during the hold phase of sample circuit 105, the hold phase may also be referred to as the conversion phase for ADC 100. During the sample phase, sample circuit 105 may pass the input voltage VIN to DAC 120, allowing DAC 120 to sample VIN. Subsequently, during each of the *N* number of conversion steps, ADC 100 may determine one bit of the *N*-bit digital output (and the N-bit digital feedback signal), starting with the most significant bit and ending with the least significant bit. For example, a 4-bit embodiment of ADC 100 may begin with SAR logic 140 setting a 4-bit mid-point value of 0111. For each bit position with a "1," the capacitor of the corresponding switch capacitor circuit within DAC 120 may be charged to a value of VREF_OUT. For each bit position with a "0," the capacitor of the corresponding switch capacitor circuit within DAC 120 may be discharged to a negative reference value such as ground GND. The charge may then be redistributed over the total DAC capacitance, and DAC 120 may output a differential signal to comparator 130.

Comparator 130 may be coupled to DAC 120 and may be configured to generate a comparison signal based on the DAC output. For example, comparator 130 may generate a comparison signal based on the differential output from DAC 120. If the differential output of DAC 120 is positive, comparator may output a logic-1. And if the differential output of DAC 120 is negative, comparator may output a logic-0. Successive-approximation register (SAR) logic 140 may be coupled to receive the comparison signal from comparator 130 and to provide the N-bit digital feedback signal to DAC 120. For example, SAR logic 140 may store the output of comparator 130 in the most-significant bit position. After determining the most-significant bit, SAR logic 140 may move to the next successive bit, setting the remaining three bits at a mid-point value of 011. The above conversion step may be repeated until each bit of the 4 bits is successively determined and the conversion phase is thus complete. After completion of the *N*-bit conversion steps during the conversion phase, the *N*-bit output signal from SAR logic 140 may provide a digital representation of the analog VIN signal.

Although the example above has been described in the context of a 4-bit SAR ADC, ADC 100 may be implemented with more or less bits than 4. ADC 100 may be implemented as, for example, an ADC with 4 bits, 6 bits, 8 bits, 10 bits, 12 bits, 14 bits, or more.

FIG. 2 illustrates a schematic diagram of sample circuit 105 in accordance with embodiments of the present disclosure. Sample circuit 105 may be implemented in any suitable fashion according to the operation described in the present disclosure. As shown in FIG. 2, sample circuit 105 may include signal generator 210 and bootstrapped switch circuit 220.

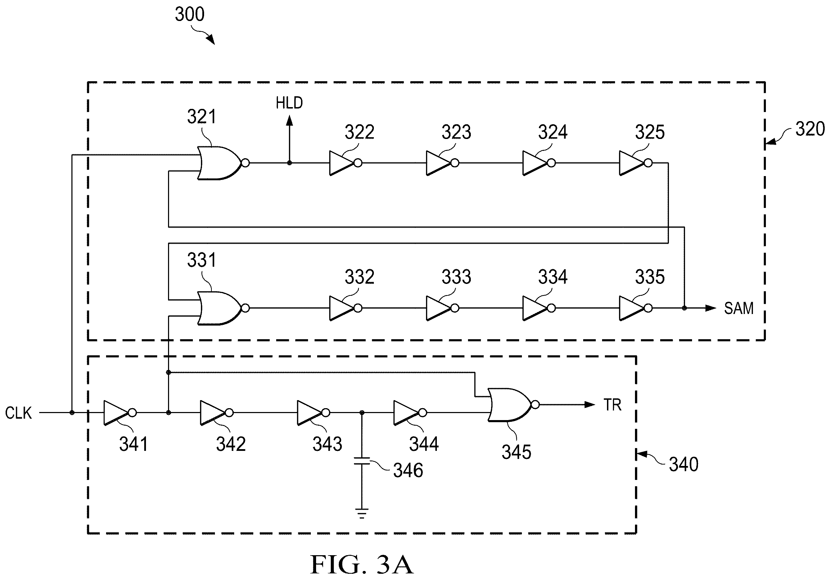

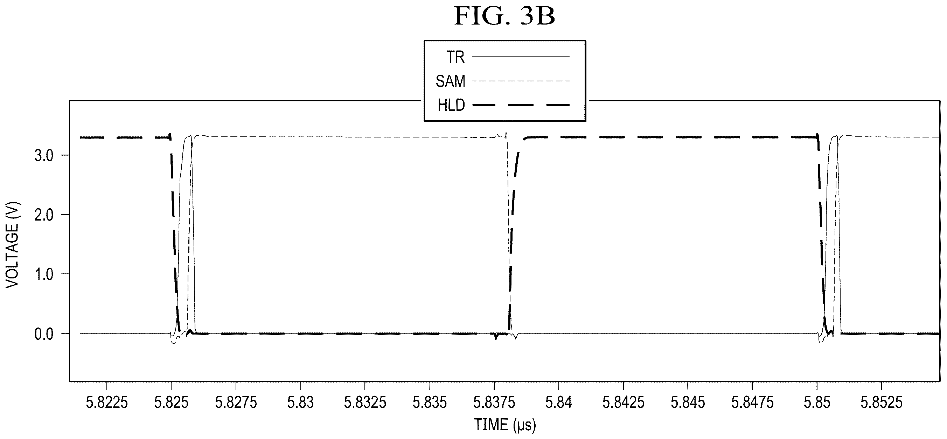

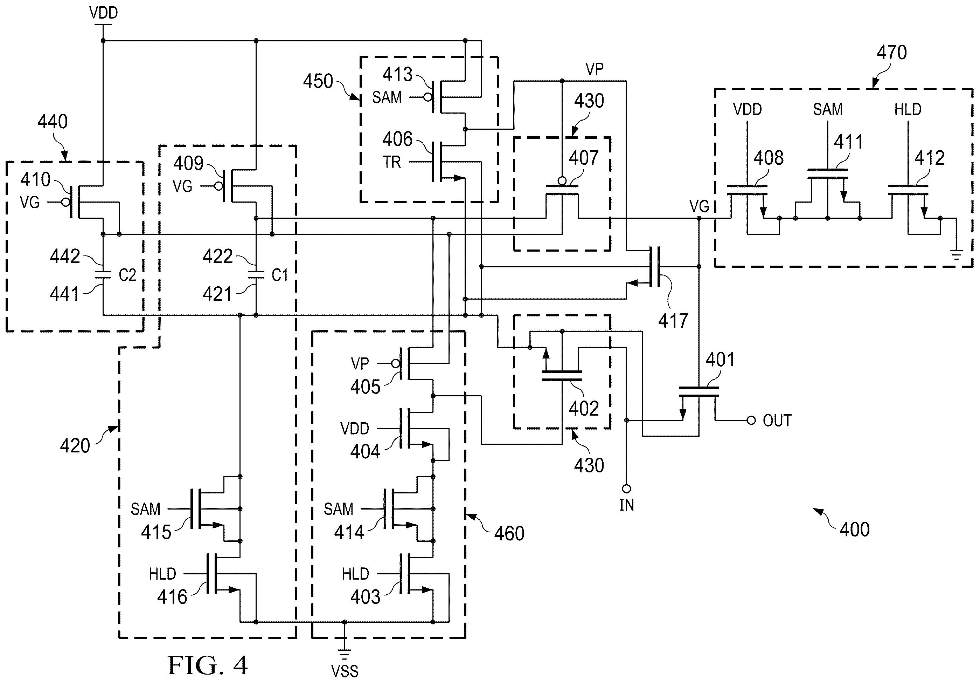

In some embodiments, signal generator 210 may be configured to generate a sample signal SAM, a hold signal HLD, and a tracking signal TR, based on the clock signal CLK. The generation of the sample signal SAM, the hold signal HLD, and the tracking signal TR is described in further detail below with reference to FIGS. 3A and 3B. As shown in FIG. 2, bootstrapped switch circuit 220 may be coupled to signal generator 210 and may receive the sample signal SAM, the hold signal HLD, and the tracking signal TR from signal generator 210. Bootstrapped switch circuit 220 may be configured to pass an input signal from an input terminal IN to an output terminal OUT during a sample phase, and to isolate the input terminal IN from the output terminal OUT during a hold phase. Example embodiments of bootstrapped switch circuit 220 are described in further detail below with reference to FIG. 4.

FIG. 3A illustrates a schematic diagram of signal generator 300 in accordance with embodiments of the present disclosure. Signal generator 300 may represent an embodiment of signal generator 210 within sample circuit 105 described above with reference to FIG. 2. In some embodiments, signal generator 300 may include non-overlap circuit 320 and one-shot circuit 340.

Non-overlap circuit 320 may be implemented in any suitable fashion according to the operation described in the present disclosure. In some embodiments, non-overlap circuit 320 may include NOR gate 321, inverters 322, 323, 324, and 325, NOR gate 331, and inverters 332, 333, 334, and 335. As shown in FIG. 3A, inverters 322 through 325 may be coupled in series between the output of NOR gate 321 and a first input of NOR gate 331. Likewise, inverters 332 through 335 may be coupled in series between the output of NOR gate 331 and a first input of NOR gate 321. Further, NOR gate 321 may receive the clock signal CLK at a second input, and NOR gate 331 may receive an inversion of the clock signal CLK at a second input. The output of NOR gate 321 may be tabbed as the hold signal HLD. Further, the output of inverter 335 may be tabbed as the sample signal SAM.

In some embodiments, such as shown in FIG. 3A, a logic-high assertion of the sample signal SAM may be non-overlapping with a logic-high assertion of the hold signal HLD. For example, during a logic-low state of the clock signal CLK, the sample signal SAM may be at a logic-low state, and the hold signal may be at a logic-high state. On a subsequent rising edge of the clock signal CLK, the hold signal HLD may first transition to a logic-low state before traversing through the non-overlap logic and causing the sample signal SAM to transition to a logic-high state. Then, on a subsequent falling edge of the clock signal CLK, the sample signal SAM may first transition to a logic-low stage before thereby causing NOR gate 321 to transition the hold signal HLD to a logic-high state.

One-shot circuit 340 may be implemented in any suitable fashion according to the operation described in the present disclosure. In some embodiments, one shot may include inverters 341, 342, 343, and 344, as well as NOR gate 345 and capacitor 346. As shown in FIG. 3A, inverters 341 through 344 may be coupled in series between the clock signal input and a first input to NOR gate 345. NOR gate 345 may also include a second input coupled to the output of inverter 341. Further, a delay element may be placed at the output of one of inverters 342, 343, and 344. For example, as shown in FIG. 3A, capacitor 346 may be coupled to the output of inverter 343.

In some embodiments, one-shot circuit 340 may provide a one-shot logic-high assertion of the tracking signal TR in response to the rising edge of the clock signal CLK. For example, when the clock signal CLK is at a logic-low state, inverter 341 and NOR gate 345 may collectively force the tracking signal TR to a logic-low state. Subsequently, on the rising edge of the clock signal CLK, the output of inverter 341 may transition low, driving the second input of NOR gate 345 in a logic-low state. The output of inverter 341 may also traverse inverters 342, 343, and 344 to force the first input of NOR gate 345 to a logic-high state. However, capacitor 346 may introduce a delay in the path through inverters 342, 343, and 344. Accordingly, both inputs of NOR gate 345 may be held at a logic-low state during a delay time, thereby generating a one-shot assertion of the tracking signal TR at a logic-high state for a period corresponding to the delay introduced by capacitor 346, inverter 343, and inverter 344.

FIG. 3B illustrates a plot diagram of waveforms generated by signal generator 300 in accordance with embodiments of the present disclosure. Specifically, FIG. 3B illustrates waveforms of the sample signal SAM, the hold signal HLD, and the tracking signal TR. The time during which the tracking signal TR and/or the sample signal SAM is asserted may collectively represent the sample phase of the bootstrapped switch circuit described in further detail below with reference to FIG. 4. Further the time during which the hold signal HLD is asserted may represent the hold phase of the bootstrapped switch circuit.

As shown in FIG. 3B, one-shot circuit 340 may be configured to assert the tracking signal TR, for example at a logic-high level, during the initial portion of the sample phase. Moreover, non-overlap circuit 320 may be configured to assert, for example at logic-high levels, the sample signal SAM during the sample phase and the hold signal during the hold phase. In some embodiments, and as shown in FIG. 3B, the assertion of the hold signal HLD at a logic-high level may be non-overlapping with the collective assertions of both the tracking signal TR and the sample signal SAM at logic-high levels.

Although the example embodiments described herein refer to the respective assertions of the tracking signal TR, the sample signal SAM, and the hold signal HLD signal at logic-high levels, in other embodiments signal generator 300 may be configured such that the non-overlapping assertions of the aforementioned signals are at a logic-low level. For such other embodiments, the bootstrapped switch circuit described below with reference to FIG. 4 may correspondingly be configured to respond to the opposite polarity of the tracking signal TR, the sample signal SAM, and the hold signal HLD.

FIG. 4 illustrates a transistor-level schematic diagram for bootstrapped switch circuit 400 in accordance with embodiments of the present disclosure. Bootstrapped switch circuit 400 may represent an embodiment of bootstrapped switch circuit 220 of sample circuit 105 described above with reference to FIG. 1 and FIG. 2. Bootstrapped switch circuit 400 may be implemented in any suitable fashion according to the operation described in the present disclosure. In some embodiments, bootstrapped switch circuit 400 may include sample transistor 401, bootstrap capacitor C1, charge path 420, bootstrap path 430, bootstrap transistor 417, auxiliary circuit 440, high-side drive circuit 450, low-side drive circuit 460, and reset path 470.

As described in detail directly below, the circuitry of bootstrapped switch circuit 400 may drive sample transistor 401 in an off-state during a hold phase, thereby isolating the output terminal OUT from the voltage at the input terminal IN during the hold phase. The circuitry of bootstrapped switch circuit 400 may also charge bootstrap capacitor C1 during the hold phase. Then, during a subsequent sample phase, the circuitry of bootstrapped switch circuit 400 may provide a bootstrapped voltage to the gate of sample transistor 401, such that sample transistor 401 is driven in an on-state and may pass a voltage from the input terminal IN to the output terminal OUT. The voltage at the output terminal OUT may thus be sampled during the sample phase by downstream circuitry, such as the capacitive DAC 120 described above with reference to FIG. 1. Bootstrapped switch circuit 400 may alternate between such sample and hold phases according to the sampling rate of the application in which bootstrapped switch circuit 400 is implemented.

Bootstrapped switch circuit 400 may be powered by a high power supply terminal VDD and a low power supply terminal VSS. In some embodiments, VDD and VSS may be shared by bootstrapped switch circuit 400 with the further components of ADC 100 described above with reference to FIG. 1, such as the DAC 120, comparator 130, and/or SAR logic 140. High power supply terminal VDD may provide the upper voltage supply, for example at 5.0 volts, 3.3 volts, or any other voltage suitable to supply the components of ADC 100 including bootstrapped switch circuit 400. Low power supply terminal VSS may provide the lower voltage supply, for example at 0 volts or ground.

Sample transistor 401 may comprise a gate coupled to node VG, a source coupled to an input terminal IN of bootstrapped switch circuit 400, and a drain coupled to an output terminal OUT of bootstrapped switch circuit 400. In some embodiments, sample transistor may be an n-type metal-oxide semiconductor field-effect transistor ("n-type MOSFET" or "NMOS transistor"). As shown in FIG. 4, the body terminal of sample transistor 401 may be coupled to the first terminal 421 of bootstrap capacitor C1. Such coupling of the body terminal of sample transistor 401 to the first terminal 421 of bootstrap capacitor C1 instead of to the source of sample transistor 401 may prevent the body-to-drain parasitic diode of sample transistor 401 from conducting, for example during hold phases where the voltage at the input terminal IN is higher than the previous sample being held by downstream circuitry, such as DAC 120, coupled to the output terminal OUT.

Charge path 420 may be configured to charge bootstrap capacitor C1 during the hold phase. Charge path 420 may include high-side charge transistor 409 and low-side charge transistor 416. In some embodiments, high-side charge transistor 409 may be a p-type metal-oxide semiconductor field-effect transistor ("p-type MOSFET" or "PMOS transistor"). And in some embodiments, low-side charge transistor 416 may be an NMOS transistor.

Low-side charge transistor 416 may be coupled between the low power supply terminal VSS and the first terminal 421 of the bootstrap capacitor C1. Further, a gate of the low-side charge transistor may be driven by the hold signal HLD to drive the low-side charge transistor in an on-state during the hold phase and in an off-state during the sample phase. Thus, during the hold phase, low-side charge transistor 416 may pull the voltage at the first terminal 421 of bootstrap capacitor C1 down to the voltage level of VSS.

High-side charge transistor 409 may be coupled between a high power supply terminal VDD and the second terminal 422 of bootstrap capacitor C1. Further, a gate of the high-side charge transistor 409 may be coupled to the gate of sample transistor 401 at node VG. Thus, when the gate of the NMOS sample transistor 401 is driven low during the hold phase to turn off sample transistor 401, the PMOS high-side charge transistor 409 may be driven in an on-state to pull the voltage at the second terminal 422 of bootstrap capacitor C1 up to the voltage level VDD. Accordingly, low-side charge transistor 416 and high-side charge transistor 409 may together charge bootstrap capacitor C1 to a voltage level of VDD minus VSS during the hold phase. As described in further detail below, this voltage level of VDD minus VSS may be applied as a bootstrapped voltage from the source to the gate of sample transistor 401 during the sample phase.

As shown in FIG. 4, charge path 420 may further include charge-path dummy transistor 415. In some embodiments, charge-path dummy transistor 415 may have a drain and a source coupled to the drain of low-side charge transistor 416. The body of charge-path dummy transistor 415 may also be coupled to the drain of low-side charge transistor 416. In some embodiments, charge-path dummy transistor 415 may further have a gate driven by the sample signal SAM having an opposite phase relative to the hold signal HLD. Charge-path dummy transistor 415 may be of matching conductivity type as low-side charge transistor 416. For example, charge-path dummy transistor 415 may be an NMOS transistor.

Charge-path dummy transistor 415 may thus be configured to offset noise injected into bootstrapped switch circuit 400 due to the transitions of the hold signal HLD at the gate of low-side charge transistor 416. For example, the sample signal SAM at the gate of charge-path dummy transistor 415 may have an opposite phase as the hold signal HLD at the gate of low-side charge transistor 416. Thus, a low-to-high or a high-to-low transition of the sample signal SAM may correspond to an opposite high-to-low or low-to-high transition of the hold signal HLD. Noise injected at the drain of low-side charge transistor 416 via the gate-to-drain capacitance of low-side charge transistor 416 due to transitions of the hold signal HLD may be offset by an opposite noise injected via the gate-to-drain and gate-to-source capacitances of charge-path dummy transistor 415 due to corresponding transitions of the sample signal SAM. In some embodiments, charge-path dummy transistor 415 may be configured with a second size that is one-half of a first size of low-side charge transistor 416. Accordingly, the sum of the gate-to-drain and gate-to-source capacitances of charge-path dummy transistor 415 may match the gate-to-drain capacitance of low-side charge transistor 416. As such, the compensation provided by charge-path dummy transistor 415 may be of equal magnitude as the noise caused by low-side charge transistor 416.

Bootstrap path 430 may be configured to apply a voltage of bootstrap capacitor C1 to the gate of sample transistor 401 during a sample phase. As shown in FIG. 4, the bootstrap path may be collectively formed by low-side transistor 402 and high-side transistor 407.

Low-side transistor 402 may be configured to couple the first terminal 421 of bootstrap capacitor C1 to the source of sample transistor 401 at the input terminal VIN during the sample phase. For example, low-side transistor 402 may be an NMOS transistor with a drain coupled to the source of sample transistor 401 and the input terminal IN, and a source coupled to the first terminal 421 of bootstrap capacitor C1. As described in further detail below with reference to low-side drive circuit 460, the gate of low-side transistor 402 may be driven high during the sample phase to turn on low-side transistor 402 and thereby couple the first terminal 421 of bootstrap capacitor C1 to the source of sample transistor 401 during the sample phase.

High-side transistor 407 may be configured to couple the second terminal 422 of bootstrap capacitor C1 to the gate of sample transistor 401 during the sample phase. For example, high-side transistor 407 may be a PMOS transistor with a source coupled to the second terminal 422 of bootstrap capacitor C1 and a drain coupled to the gate of sample transistor 401 at node VG. As described in further detail below with reference to the high-side drive circuit 450 and bootstrap transistor 417, the gate of high-side transistor 407 may be driven low during the sample phase to turn on high-side transistor 407 and thereby couple the second terminal 422 of bootstrap capacitor C1 to the gate of sample transistor 401 during the sample phase.

High-side drive circuit 450 may be configured in conjunction with bootstrap transistor 417 to drive high-side transistor 407 in an on-state during the sample phase and in an off-state during the hold phase. High-side drive circuit 450 may include first high-side drive transistor 413 and second high-side drive transistor 406. In some embodiments, first high-side drive transistor 413 may be a PMOS transistor. And in some embodiments, second high-side drive transistor 406 may be an NMOS transistor.

As shown in FIG. 4, first high-side drive transistor 413 may be coupled between high power supply terminal VDD and the gate of high-side transistor 407 at node VP. The gate of first high-side drive transistor 413 may be driven by the sample signal SAM to drive first high-side drive transistor 413 in an off-state during the sample phase and in an on-state during the hold phase. As also shown in FIG. 4, second high-side drive transistor 406 may be coupled between the gate of high-side transistor 407 at node VP and the first terminal 421 of bootstrap capacitor C1. The gate of second high-side drive transistor 406 may be driven by the tracking signal TR to drive second high-side drive transistor 406 in an on-state during an initial portion of the sample phase and to drive second high-side drive transistor 406 in an off-state during a remaining portion of the sample phase and further during the hold phase.

Referring back to FIG. 3B, the tracking signal TR may be asserted at a logic-high level during an initial portion of the sample phase. During this initial portion of the sample phase, second high-side drive transistor 406 may drive the gate of high-side transistor 407 low to the voltage level of the first terminal 421 of bootstrap capacitor C1, thereby turning on high-side transistor 407. As described above, high-side transistor 407 in turn couples the gate of sample transistor 401 to the bootstrapped voltage at the second terminal 422 of bootstrap capacitor C2. Likewise, low-side transistor 402 is turned on to couple the source of sample transistor 401 at input terminal IN to the first terminal 421 of bootstrap capacitor C2. Accordingly, a full bootstrapped voltage equal to VDD minus VSS may be applied across the gate to source of sample transistor 401.

As shown in FIG. 4, bootstrap transistor 417 may be configured to maintain the on-state of high-side transistor 407 during the sample phase after high-side transistor 407 is initially turned on during the sample phase by second high-side drive transistor 406. For example, bootstrap transistor 417 may have a gate coupled to the gate of sample transistor 401 at node VG. Bootstrap transistor 417 may also have a drain coupled to the gate of high-side transistor 407 and a source coupled to the first terminal 421 of bootstrap capacitor C1. Accordingly, after the tracking signal TR turns second high-side drive transistor 406 back off after the initial portion of the sample phase, bootstrap transistor 417 may utilize the bootstrap voltage established at node VG to maintain high-side transistor 407 in an off-state for the remainder of the sample phase.

The use of bootstrap transistor 417 provides bootstrapped switch circuit 400 with multiple advantages. As one advantage, the use of bootstrap transistor 417 may allow bootstrapped switch circuit 400 to operate with good linearity across a full range of input voltages from VSS to VDD. For example, in some embodiments, logic-levels of the tracking signal TR, sample signal SAM, and hold signal HLD may be at the same voltage level as VDD. Because the source of second high-side drive transistor 406 is coupled to the first terminal 421 of bootstrap capacitor C1, second high-side drive transistor 406 may limit the input range of bootstrapped switch circuit 400 to an upper value of VDD minus the gate-to-source threshold of second high-side drive transistor 406 if not for the presence of bootstrap transistor 417. Because bootstrap transistor 417 applies a bootstrapped voltage to maintain high-side transistor 407 in an off-state during the sample phase, the input range of bootstrapped switch circuit 400 is not limited by the gate-to-source voltage of bootstrap transistor 417. Accordingly, bootstrap transistor 417 may allow bootstrapped switch circuit 400 to apply a full bootstrapped voltage of VDD minus VSS across the gate to source of sample transistor 401 for a full range of input values at input terminal IN from VSS to VDD. Bootstrap transistor 417 may thus improve the linearity of bootstrapped switch circuit 400 across the full range of input values at input terminal IN from VSS to VDD.

Further, the use of bootstrap transistor 417 may allow for the reduction of noise and parasitic capacitance at node VP coupled to the gate of high-side transistor 407. For example, bootstrap transistor 417 maintains high-side transistor 407 in an on-state for the remainder of the sample phase after second high-side drive transistor 406 turns on high-side transistor 407 during an initial portion of the sample phase. Thus, second high-side drive transistor 406 may be driven by a tracking signal TR that returns to an unasserted, logic-low level, after the initial portion of the sample phase. Accordingly, noise injected into node VP due to the parasitic gate-to-drain capacitance of second high-side drive transistor 406 during the low-to-high transition of the tracking signal TR may be offset by an opposing noise during subsequent high-to-low transition of the tracking signal TR shortly thereafter. Moreover, the parasitic gate-to-drain capacitance of second high-side drive transistor 406 may be voltage dependent with a lower parasitic capacitance value when the tracking signal TR is at a logic-low level. Thus, during the transition of bootstrapped switch circuit 400 from a sample phase to a hold phase, the parasitic capacitance present at node VP may be reduced because the tracking signal TR is already at a logic-low level prior to the transition from the sample phase to the hold phase. With a smaller parasitic capacitance present at node VP, high-side transistor 407 may be turned off more quickly, creating a sharper and more sudden transition from the sample phase to the hold phase. Specifically, when the sample signal SAM goes low at the beginning of the hold phase, first high-side drive transistor 413 may pull the gate of high-side transistor 407 at node VP to VDD to turn off high-side transistor 407. With a lower parasitic capacitance present at node VP, first high-side drive transistor 413 may provide a faster turn-off for high-side transistor 407.

Low-side drive circuit 460 may be configured to drive low-side transistor 402 in an on-state during the sample phase and in an off-state during the hold phase. Low-side drive circuit 460 may include first low-side drive transistor 405, cascode transistor 404, and second low-side drive transistor 403. In some embodiments, first low-side drive transistor 405 may be a PMOS transistor. And in some embodiments, cascode transistor 404 and second low-side drive transistor 403 may be NMOS transistors.

As shown in FIG. 4, first low-side drive transistor 405 may be coupled between the second terminal 422 of bootstrap capacitor C1 and a gate of low-side transistor 402. In some embodiments, a gate of the first low-side drive transistor 405 may be coupled to the gate of high-side transistor 407 at node VP. Thus, when high-side transistor 407 is turned on during the sample phase, first low-side drive transistor 405 may likewise be turned on, thereby pulling the gate of low-side transistor 402 high to the bootstrap voltage level at the second terminal 422 of bootstrap capacitor C1. Thus, during the sample phase, first low-side drive transistor 405 may pull the voltage at the gate of low-side transistor 402 high to the bootstrap voltage level to drive low-side transistor 402 in an on-state.

Cascode transistor 404 may be coupled in series between first low-side drive transistor 405 and second low-side drive transistor 403. Cascode transistor 404 may have a gate coupled to VDD. Cascode transistor 404 may thus provide a cascode for second low-side drive transistor 403 by preventing the voltage at the source of cascode transistor 404 from rising above the voltage level of VDD minus the gate-to-source threshold of cascode transistor 404.

As also shown in FIG. 4, second low-side drive transistor 403 may be coupled between the gate of low-side transistor 402 and the low power supply terminal VSS. For example, the drain of second low-side drive transistor 403 may be coupled to the gate of low-side transistor 402 via cascode transistor 404. Further, the source of second low-side drive transistor 403 may be coupled to VSS. The gate of second low-side drive transistor 403 may be driven by the hold signal HLD to drive second low-side drive transistor 403 in an on-state during the hold phase and in an off-state during the sample phase. For example, when hold signal HLD is at a logic-low level during the sample phase, second low-side drive transistor 403 may be held in an off-state. And when hold signal HLD is at a logic-high level during the hold phase, second low-side drive transistor 403 may be held in an on-state. Thus, during the hold phase, second low-side drive transistor 403 may pull the voltage at the gate of low-side transistor 402 low to VSS to drive low-side transistor 402 in an off-state.

According to the functionality described above, low-side drive circuit 460 may improve the speed of bootstrapped switch circuit 400. For example, by driving low-side transistor 402 with low-side drive circuit 460 instead of the bootstrap voltage at node VG, low-side transistor 402 may be turned on and off faster, thus providing a more accurate window for the sampling time of bootstrapped switch circuit 400. Further, by driving the gate of low-side transistor 402 with low-side drive circuit 460 instead of the bootstrap voltage at node VG, the parasitic capacitance present at node VG may be reduced. Accordingly, bootstrapped switch circuit 400 may transition the voltage at node VG to drive transistor 401 on and off faster, thus further providing a more accurate window for the sampling time of bootstrapped switch circuit 400.

As shown in FIG. 4, low-side drive circuit 460 may further include low-side dummy transistor 414. In some embodiments, low-side dummy transistor 414 may have a drain and a source coupled together and to the drain of second low-side drive transistor 403. The body of low-side dummy transistor 414 may also be coupled to the drain of second low-side drive transistor 403. In some embodiments, low-side dummy transistor 414 may further have a gate driven by the sample signal SAM having an opposite phase relative to the hold signal HLD. Low-side dummy transistor 414 may be of matching conductivity type as second low-side drive transistor 403. For example, low-side dummy transistor 414 may be an NMOS transistor.

Low-side dummy transistor 414 may thus be configured to offset noise injected into bootstrapped switch circuit 400 due to the transitions of the hold signal HLD at the gate of second low-side drive transistor 403. For example, the sample signal SAM at the gate of low-side dummy transistor 414 may have an opposite phase as the hold signal HLD at the gate of second low-side drive transistor 403. Thus, a low-to-high or a high-to-low transition of the sample signal SAM may correspond to an opposite high-to-low or low-to-high transition of the hold signal HLD. Noise injected at the drain of second low-side drive transistor 403 via the gate-to-drain capacitance of second low-side drive transistor 403 due to transitions of the hold signal HLD may be offset by an opposite noise injected via the gate-to-drain and gate-to-source capacitances of low-side dummy transistor 414 due to corresponding transitions of the sample signal SAM. In some embodiments, low-side dummy transistor 414 may be configured with a second size that is one-half of a first size of second low-side drive transistor 403. Accordingly, the sum of the gate-to-drain and gate-to-source capacitances of low-side dummy transistor 414 may match the gate-to-drain capacitance of second low-side drive transistor 403. As such, the compensation provided by low-side dummy transistor 414 may be of equal magnitude as the noise caused by second low-side drive transistor 403.

Auxiliary circuit 440 may be configured to provide an auxiliary bootstrapped voltage at node VH to which the body terminals of certain PMOS transistors within bootstrapped switch circuit 400 may be coupled. As shown in FIG. 4, auxiliary circuit 440 may include auxiliary capacitor C2 and auxiliary transistor 410. In some embodiments, auxiliary capacitor C2 and auxiliary transistor 410 may be configured in a similar manner as bootstrap capacitor C1 and high-side charge transistor 409. For example, auxiliary capacitor C2 may have a first terminal 441 coupled to the first terminal 421 of bootstrap capacitor C1. Further, auxiliary transistor 410 may be coupled between a second terminal 442 of auxiliary capacitor C2 and the high power supply terminal VDD. The gate of auxiliary transistor 410 may be coupled to the gate of sample transistor 401 at node VG. Thus, in similar manner as described above for bootstrap capacitor C1, a bootstrap voltage at a level of VDD minus VSS may be developed across auxiliary capacitor C2 during the hold phase.

In some embodiments, the body terminal of high-side transistor 407, the body terminal of high-side charge transistor 409, the body terminal of first low-side drive transistor 405, and/or the body terminal of auxiliary transistor 410 may be coupled to the second terminal 442 of auxiliary capacitor C2. Such coupling may improve the reliability of the aforementioned transistors, and thus of bootstrapped switch circuit 400 as a whole. For example, auxiliary capacitor C2 may be sized at a large enough capacitance value to hold the body terminals of high-side transistor 407, first low-side drive transistor 405, and high-side charge transistor 409, at the intended bootstrap voltage, but nonetheless at a capacitance value lower than that of bootstrap capacitor C1. For example, auxiliary capacitor C2 may have a second capacitance that is less than a first capacitance of bootstrap capacitor C1 by a factor of at least 2, 4, 8, 12, 16, or more. The transient spikes present at the second terminal 442 of auxiliary capacitor C2 may thus be smaller by a factor of at least 2, 4, 8, 12, 16, or more, than the transient spikes present at the second terminal 422 of bootstrap capacitor C1 during the transitions back and forth between sample and hold phases. Thus, coupling the body terminals of high-side transistor 407, first low-side drive transistor 405, and/or high-side charge transistor 409 to the second terminal 442 of auxiliary capacitor C2 may reduce the likelihood of a transient spike causing current to flow through the parasitic body-to-source diodes of the aforementioned PMOS transistors and thereby damaging one or more of the aforementioned PMOS transistors.

Auxiliary circuit 440 may also improve the linearity of bootstrapped switch circuit 400. For example, coupling the respective body terminals of high-side transistor 407, high-side charge transistor 409, and first low-side drive transistor 405, to the second terminal 442 of auxiliary capacitor C2 instead of the second terminal 422 of bootstrap capacitor C1 may reduce the parasitic capacitance at the second terminal 422 of bootstrap capacitor C1. For example, the bootstrap voltage applied to node VG (relative to the input voltage received at the input terminal IN) may be equal to VDD times the capacitance of bootstrap capacitor C1 divided by the sum of the capacitance of bootstrap capacitor C1 plus the parasitic capacitance (Cpar) at the second terminal 422 of bootstrap capacitor C1 (bootstrap voltage applied to VG = VDD * (C1 / (C1 + Cpar))). By lowering the parasitic capacitance at the second terminal 422 of bootstrap capacitor C1, the magnitude of the bootstrap voltage applied to node VG (relative to the input voltage received at the input terminal IN) may be improved. Moreover, the parasitic junction capacitances of high-side transistor 407, high-side charge transistor 409, and first low-side drive transistor 405 may each be dependent on, and vary with, the voltage level of the input signal received at the input terminal IN, the voltage level of VDD, temperature, and semiconductor process variation. Thus, coupling the respective body terminals of high-side transistor 407, high-side charge transistor 409, and first low-side drive transistor 405, to the second terminal 442 of auxiliary capacitor C2 instead of the second terminal 422 of bootstrap capacitor C1 may prevent such dependencies from affecting the bootstrap voltage, thereby improving the linearity of bootstrapped switch circuit 400 across different variables such as the voltage level of the input signal received at the input terminal IN, the voltage level of VDD, temperature, and semiconductor process variation.

Reset path 470 may be configured to pull the voltage at the gate of sample transistor 401 low toward VSS during the hold phase, thereby driving sample transistor 401 in an off-state during the hold phase. As shown in FIG. 4, reset path 470 may include cascode transistor 408 and reset transistor 412. In some embodiments, cascode transistor 408 and reset transistor 412 may be NMOS transistors.

Cascode transistor 408 may be coupled in series between the gate of sample transistor 401 at node VG and reset transistor 412. Cascode transistor 408 may have a gate coupled to VDD. Cascode transistor 408 may thus provide a cascode for reset transistor 412 by preventing the voltage at the source of cascode transistor 408 from rising above the voltage level of VDD minus the gate-to-source threshold of cascode transistor 408.

As also shown in FIG. 4, reset transistor 412 may be coupled between the gate of sample transistor 401 and the low power supply terminal VSS. For example, the drain of reset transistor 412 may be coupled to the gate of sample transistor 401 via cascode transistor 408. Further, the source of reset transistor 412 may be coupled to VSS. The gate of reset transistor 412 may be driven by the hold signal HLD to drive reset transistor in an on-state during the hold phase and in an off-state during the sample phase. For example, when hold signal HLD is at a logic-low level during the sample phase, reset transistor 412 may be held in an off-state. And when hold signal HLD is at a logic-high level during the hold phase, reset transistor 412 may be held in an on-state. Thus, during the hold phase, reset transistor 412 may pull the voltage at the gate of sample transistor 401 low to VSS to drive sample transistor 401 in an off-state.

As shown in FIG. 4, reset path 470 may further include reset dummy transistor 411. In some embodiments, reset dummy transistor 411 may have a drain and a source coupled together and to the drain of reset transistor 412. The body of reset dummy transistor 411 may also be coupled to the drain of reset transistor 412. In some embodiments, reset dummy transistor 411 may further have a gate driven by the sample signal SAM having an opposite phase relative to the hold signal HLD. Reset dummy transistor 411 may be of matching conductivity type as reset transistor 412. For example, reset dummy transistor 411 may be an NMOS transistor.

Reset dummy transistor 411 may thus be configured to offset noise injected into bootstrapped switch circuit 400 due to the transitions of the hold signal HLD at the gate of reset transistor 412. For example, the sample signal SAM at the gate of reset dummy transistor 411 may have an opposite phase as the hold signal HLD at the gate of reset transistor 412. Thus, a low-to-high or a high-to-low transition of the sample signal SAM may correspond to an opposite high-to-low or low-to-high transition of the hold signal HLD. Noise injected at the drain of reset transistor 412 via the gate-to-drain capacitance of reset transistor 412 due to transitions of the hold signal HLD may be offset by an opposite noise injected via the gate-to-drain and gate-to-source capacitances of reset dummy transistor 411 due to corresponding transitions of the sample signal SAM. In some embodiments, reset dummy transistor 411 may be configured with a second size that is one-half of a first size of reset transistor 412. Accordingly, the sum of the gate-to-drain and gate-to-source capacitances of reset dummy transistor 411 may match the gate-to-drain capacitance of reset transistor 412. As such, the compensation provided by reset dummy transistor 411 may be of equal magnitude as the noise caused by reset transistor 412.

Embodiments herein may include a sample circuit. The sample circuit includes a signal generator configured to generate a sample signal, a hold signal, and a tracking signal. The sample circuit also includes a bootstrapped switch circuit. The bootstrapped switch circuit includes a sample transistor comprising a gate, a source coupled to an input terminal and a drain coupled to an output terminal of the bootstrapped switch circuit. The bootstrapped switch circuit also includes a bootstrap capacitor, a charge path configured to charge the bootstrap capacitor during a hold phase, and a bootstrap path configured to apply a voltage of the bootstrap capacitor to the gate of the sample transistor during a sample phase. The bootstrap path includes a low-side transistor configured to couple a first terminal of the bootstrap capacitor to the source of the sample transistor during the sample phase. The bootstrap path also includes a high-side transistor configured to couple a second terminal of the bootstrap capacitor to the gate of the sample transistor during the sample phase. The bootstrapped switch circuit further includes a bootstrap transistor having gate coupled to the gate of the sample transistor and a drain coupled to a gate of the high-side transistor, the bootstrap transistor configured to maintain an on-state of the high-side transistor during the sample phase after the high-side transistor is initially turned on during the sample phase. In addition, the bootstrapped switch circuit includes a high-side drive circuit including a first high-side drive transistor coupled between a high power supply terminal and the gate of the high-side transistor, and a second high-side drive transistor coupled between the gate of the high-side transistor the first terminal of the bootstrap capacitor. The gate of the first high-side drive transistor is driven by the sample signal to drive the first high-side drive transistor in an off-state during the sample phase and in an on-state during the hold phase. Further, a gate of the second high-side drive transistor is driven by the tracking signal to drive the second high-side drive transistor in an on-state during an initial portion of the sample phase and to drive the second high-side drive transistor in an off-state during a remaining portion of the sample phase and further during the hold phase.

The sample circuit may have one or more of the following additional elements in any combination. Element 1: wherein the signal generator comprises: a non-overlap circuit configured to assert the sample signal during the sample phase and the hold signal during the hold phase, and a one-shot circuit configured to assert the tracking signal during the initial portion of the sample phase.

Embodiments herein may include an analog-to-digital converter (ADC). The ADC includes a bootstrapped switch circuit. The bootstrapped switch circuit includes a sample transistor comprising a gate, a source coupled to an input terminal, and a drain coupled to an output terminal of the bootstrapped switch circuit. The bootstrapped switch circuit also includes a bootstrap capacitor, a charge path configured to charge the bootstrap capacitor during a hold phase, and a bootstrap path configured to apply a voltage of the bootstrap capacitor to the gate of the sample transistor during a sample phase. The bootstrap path includes a low-side transistor configured to couple a first terminal of the bootstrap capacitor to the source of the sample transistor during the sample phase, and a high-side transistor configured to couple a second terminal of the bootstrap capacitor to the gate of the sample transistor during the sample phase. In addition, the bootstrapped switch circuit includes a bootstrap transistor having gate coupled to the gate of the sample transistor and a drain coupled to a gate of the high-side transistor, the bootstrap transistor configured to maintain an on-state of the high-side transistor during the sample phase after the high-side transistor is initially turned on during the sample phase. The ADC also includes a capacitive digital-to-analog converter (DAC) configured to receive an input signal via the bootstrapped switch circuit during the sample phase and to receive a digital feedback signal during the hold phase. The ADC further includes a comparator coupled to the DAC and configured to generate a comparison signal based on a DAC output. In addition, the ADC includes a successive-approximation register (SAR) logic coupled to receive the comparison signal and to provide the digital feedback signal to the capacitive DAC.

The ADC may have one or more of the following additional elements in any combination. Element 1: wherein the bootstrapped switch circuit further comprises an auxiliary circuit including an auxiliary capacitor having a first terminal coupled to the first terminal of the bootstrap capacitor, and an auxiliary transistor coupled between a second terminal of the auxiliary capacitor and a high power supply terminal, wherein a gate of the auxiliary transistor is coupled to the gate of the sample transistor, and wherein a body terminal of the high-side transistor and a body terminal of the auxiliary transistor are coupled to the second terminal of the auxiliary capacitor. Element 2: wherein the bootstrapped switch circuit further comprises a high-side drive circuit including a first high-side drive transistor coupled between a high power supply terminal and the gate of the high-side transistor, and a second high-side drive transistor coupled between the gate of the high-side transistor the first terminal of the bootstrap capacitor, wherein a gate of the first high-side drive transistor is driven by a sample signal to drive the first high-side drive transistor in an off-state during the sample phase and in an on-state during the hold phase, and wherein a gate of the second high-side drive transistor is driven by a tracking signal to drive the second high-side drive transistor in an on-state during an initial portion of the sample phase and to drive the second high-side drive transistor in an off-state during a remaining portion of the sample phase and further during the hold phase. Element 3: wherein the bootstrapped switch circuit further comprises a low-side drive circuit including a first low-side drive transistor coupled between the second terminal of the bootstrap capacitor and a gate of the low-side transistor, wherein a gate of the first low-side drive transistor is coupled to the gate of the high-side transistor; and a second low-side drive transistor coupled between the gate of the low-side transistor and a low power supply terminal, wherein a gate of the second low-side drive transistor is driven by a hold signal to drive the second low-side drive transistor in an on-state during the hold phase and in an off-state during the sample phase.

Although examples have been described above, other modifications and variations may be made from this disclosure without departing from the spirit and scope of these examples. The above descriptions of various embodiments illustrate the principles of the invention. Numerous variations and modifications will become apparent to those skilled in the art based on the above disclosure. The following claims are intended to embrace all such variations and modifications.

## Claims

1. A bootstrapped switch circuit, comprising:
a sample transistor comprising a gate, a source coupled to an input terminal, and a drain coupled to an output terminal;
a bootstrap capacitor;
a charge path configured to charge the bootstrap capacitor during a hold phase;
a bootstrap path configured to apply a voltage of the bootstrap capacitor to the gate of the sample transistor during a sample phase, the bootstrap path including:
a low-side transistor configured to couple a first terminal of the bootstrap capacitor to the source of the sample transistor during the sample phase; and
a high-side transistor configured to couple a second terminal of the bootstrap capacitor to the gate of the sample transistor during the sample phase; and
a bootstrap transistor having gate coupled to the gate of the sample transistor and a drain coupled to a gate of the high-side transistor, the bootstrap transistor configured to maintain an on-state of the high-side transistor during the sample phase after the high-side transistor is initially turned on during the sample phase.

2. The bootstrapped switch circuit of claim 1, wherein the charge path comprises:
a high-side charge transistor coupled between a high power supply terminal and the second terminal of the bootstrap capacitor, wherein a gate of the high-side charge transistor is coupled to the gate of the sample transistor; and
a low-side charge transistor coupled between a low power supply terminal and the first terminal of the bootstrap capacitor, wherein a gate of the low-side charge transistor is driven by a hold signal to drive the low-side charge transistor in an on-state during the hold phase and in an off-state during the sample phase.

3. The bootstrapped switch circuit of claim 2, wherein the charge path further comprises a charge-path dummy transistor having a drain and a source coupled to a drain of the low-side charge transistor, the charge-path dummy transistor further having a gate driven by a sample signal having an opposite phase relative to the hold signal.

4. The bootstrapped switch circuit of claim 3, wherein the charge-path dummy transistor is configured to have a second size that is one-half of a first size of the low-side charge transistor.

5. The bootstrapped switch circuit of claim 2, further comprising an auxiliary circuit including:
an auxiliary capacitor having a first terminal coupled to the first terminal of the bootstrap capacitor; and
an auxiliary transistor coupled between a second terminal of the auxiliary capacitor and the high power supply terminal, wherein a gate of the auxiliary transistor is coupled to the gate of the sample transistor; and
wherein a body terminal of the high-side transistor, a body terminal of the high-side charge transistor, and a body terminal of the auxiliary transistor, are coupled to the second terminal of the auxiliary capacitor.

6. The bootstrapped switch circuit of claim 1, further comprising an auxiliary circuit including:
an auxiliary capacitor having a first terminal coupled to the first terminal of the bootstrap capacitor; and
an auxiliary transistor coupled between a second terminal of the auxiliary capacitor and a high power supply terminal, wherein a gate of the auxiliary transistor is coupled to the gate of the sample transistor; and
wherein a body terminal of the high-side transistor and a body terminal of the auxiliary transistor are coupled to the second terminal of the auxiliary capacitor.

7. The bootstrapped switch circuit of claim 1, further comprising a high-side drive circuit including:
a first high-side drive transistor coupled between a high power supply terminal and the gate of the high-side transistor; and
a second high-side drive transistor coupled between the gate of the high-side transistor the first terminal of the bootstrap capacitor; and
wherein a gate of the first high-side drive transistor is driven by a sample signal to drive the first high-side drive transistor in an off-state during the sample phase and in an on-state during the hold phase; and
wherein a gate of the second high-side drive transistor is driven by a tracking signal to drive the second high-side drive transistor in an on-state during an initial portion of the sample phase and to drive the second high-side drive transistor in an off-state during a remaining portion of the sample phase and further during the hold phase.

8. The bootstrapped switch circuit of claim 1, further comprising a low-side drive circuit including:
a first low-side drive transistor coupled between the second terminal of the bootstrap capacitor and a gate of the low-side transistor, wherein a gate of the first low-side drive transistor is coupled to the gate of the high-side transistor; and
a second low-side drive transistor coupled between the gate of the low-side transistor and a low power supply terminal, wherein a gate of the second low-side drive transistor is driven by a hold signal to drive the second low-side drive transistor in an on-state during the hold phase and in an off-state during the sample phase.

9. The bootstrapped switch circuit of claim 8, wherein the low-side drive circuit further includes a low-side dummy transistor having a drain and a source coupled together and to a drain of the second low-side drive transistor, the low-side dummy transistor further having a gate driven by a sample signal having an opposite phase relative to the hold signal.

10. The bootstrapped switch circuit of claim 9, wherein the low-side dummy transistor has a second size that is one-half of a first size of the second low-side drive transistor.

11. The bootstrapped switch circuit of claim 1, further comprising a reset path including:
a reset transistor coupled between the gate of the sample transistor and a low power supply terminal, wherein a gate of the reset transistor is driven by a hold signal to drive the reset transistor in an on-state during the hold phase and in an off-state during the sample phase; and
a reset dummy transistor having a drain and a source coupled together and to the drain of reset transistor, the reset dummy transistor further having a gate driven by a sample signal having an opposite phase relative to the hold signal.

12. The bootstrapped switch circuit of claim 11, wherein the reset dummy transistor is configured to have a second size that is one-half of a first size of the reset transistor.

13. A sample circuit, comprising:
a signal generator configured to generate a sample signal, a hold signal, and a tracking signal; and
a bootstrapped switch circuit comprising:
a sample transistor comprising a gate, a source coupled to an input terminal and a drain coupled to an output terminal of the bootstrapped switch circuit;
a bootstrap capacitor;
a charge path configured to charge the bootstrap capacitor during a hold phase;
a bootstrap path configured to apply a voltage of the bootstrap capacitor to the gate of the sample transistor during a sample phase, the bootstrap path including:
a low-side transistor configured to couple a first terminal of the bootstrap capacitor to the source of the sample transistor during the sample phase; and
a high-side transistor configured to couple a second terminal of the bootstrap capacitor to the gate of the sample transistor during the sample phase; and
a bootstrap transistor having gate coupled to the gate of the sample transistor and a drain coupled to a gate of the high-side transistor, the bootstrap transistor configured to maintain an on-state of the high-side transistor during the sample phase after the high-side transistor is initially turned on during the sample phase; and
a high-side drive circuit including:
a first high-side drive transistor coupled between a high power supply terminal and the gate of the high-side transistor; and
a second high-side drive transistor coupled between the gate of the high-side transistor the first terminal of the bootstrap capacitor; and
wherein a gate of the first high-side drive transistor is driven by the sample signal to drive the first high-side drive transistor in an off-state during the sample phase and in an on-state during the hold phase; and
wherein a gate of the second high-side drive transistor is driven by the tracking signal to drive the second high-side drive transistor in an on-state during an initial portion of the sample phase and to drive the second high-side drive transistor in an off-state during a remaining portion of the sample phase and further during the hold phase.

14. The sample circuit of claim 13, wherein the bootstrapped switch circuit further comprises a low-side drive circuit including:
a first low-side drive transistor coupled between the second terminal of the bootstrap capacitor and a gate of the low-side transistor, wherein a gate of the first low-side drive transistor is coupled to the gate of the high-side transistor; and
a second low-side drive transistor coupled between the gate of the low-side transistor and a low power supply terminal, wherein a gate of the second low-side drive transistor is driven by the hold signal to drive the second low-side drive transistor in an on-state during the hold phase and in an off-state during the sample phase.

15. The sample circuit of claim 14, wherein the bootstrapped switch circuit further comprises an auxiliary circuit including:
an auxiliary capacitor having a first terminal coupled to the first terminal of the bootstrap capacitor; and
an auxiliary transistor coupled between a second terminal of the auxiliary capacitor and the high power supply terminal, wherein a gate of the auxiliary transistor is coupled to the gate of the sample transistor; and
wherein a body terminal of the high-side transistor, a body terminal of the first low-side drive transistor, and a body terminal of the auxiliary transistor are coupled to the second terminal of the auxiliary capacitor.
